# EUROPÄISCHE PATENTSCHRIFT

(11) **EP 3 119 511 B1**
(45) Veröffentlichungstag und Bekanntmachung des Hinweises auf die Patenterteilung: **28.02.2018**
(21) Anmeldenummer: 15709911.0
(22) Anmeldetag: 12.03.2015
(51) Int. Cl.: B01J 8/18, B01J 8/42, C01B 33/03

(54) **REAKTOR UND VERFAHREN ZUR HERSTELLUNG VON GRANULAREM POLYSILICIUM**
REACTOR AND PROCESS FOR PREPARING GRANULAR POLYSILICON
RÉACTEUR ET PROCÉDÉ DE PRODUCTION DE POLYSILICIUM GRANULAIRE

(30) Priorität: 18.03.2014 DE 102014205025
(43) Veröffentlichungstag der Anmeldung: 25.01.2017
(73) Patentinhaber: Wacker Chemie AG, 81737 München (DE)
(72) Erfinder: WECKESSER, Dirk, 84561 Mehring (DE)
(74) Vertreter: Potten, Holger
(86) Internationale Anmeldenummer: PCT/EP2015/055143
(87) Internationale Veröffentlichungsnummer: WO 2015/140028

(56) Entgegenhaltungen:
- WO-A1-93/20933
- WO-A2-2007/130613
- US-B1- 7 029 632

## Beschreibung

Die Erfindung betrifft einen Reaktor, insbesondere einen Wirbelschichtreaktor, und ein Verfahren zur Herstellung von granularem Polysilicium.

Wirbelschichtreaktoren (auch Fließbettreaktoren) werden beispielsweise zur Herstellung von Trichlorsilan (TCS) durch die Reaktion von metallurgischem Silicium mit HCl bei 350-400° C verwendet. Ebenso kann TCS im Wirbelschichtreaktor aus metallurgischem Silicium mit STC/H₂ (STC = Siliciumtetrachlorid) erzeugt werden.

Wirbelschichtreaktoren werden auch zur Herstellung von polykristallinem Siliciumgranulat verwendet.

Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumpartikel als Keimpartikel kann das Verfahren kontinuierlich mit allen damit verbundenen Vorteilen betrieben werden. Als siliciumhaltiges Eduktgas sind Silicium-Halogenverbindungen (z. B. Chlorsilane oder Bromsilane), Monosilan (SiH₄), sowie Mischungen dieser Gase mit Wasserstoff beschrieben. Derartige Abscheideverfahren und Vorrichtungen hierzu sind beispielsweise aus US 4786477 A bekannt.

US 5382412 A offenbart ein Verfahren zur Herstellung von polykristallinem Silicium in einem Fließbettreaktor, wobei Siliciumausgangspartikel dem Reaktor zugeführt werden, um ein Bett aus Siliciumpartikeln zu bilden; das Reaktorbett in eine Reaktionszone, bei der eine gasförmige oder dampfförmige Siliciumquelle als Siliciummetall bei einer Reaktionstemperatur auf den Siliciumpartikeln abgelagert wird und in eine Heizzone, bei der eine Fraktion der Siliciumpartikel über die Reaktionstemperatur erhitzt wird, unterteilt wird; ein Reaktionsgas, das die Siliciumquelle aufweist, in die Reaktionszone eingeführt wird, wodurch die Siliciumpartikel in der Reaktionszone fluidisiert werden; ein Trägergas in die Heizzone eingeführt wird, wodurch die Siliciumpartikel in der Heizzone fluidisiert werden; die Siliciumpartikel in der Heizzone aufgeheizt werden, indem Mikrowellenenergie in die Heizzone eingeleitet wird; die Siliciumpartikel in einem oberen Bereich der Heizzone mit Siliciumpartikeln der Reaktionszone vermischt werden, wodurch Wärme aus der Heizzone in die Reaktionszone übertragen wird; und nicht reagierendes Fluidisierungsgas und Reaktionsnebenproduktgase aus dem Reaktor entfernt werden.

Mit einem derartigen Reaktor kommt es jedoch aufgrund des temperaturabhängigen Einkoppelverhaltens von Mikrowellen in Silicium und der Abhängigkeit des Energieeintrages von der Geometrie des Reaktors und der Mikrowellenzufuhr zu einer flächig ungleichmäßigen Energiezufuhr. Es kommt dabei zu starker Überhitzung einzelner Siliciumpartikel und zum Zusammensintern von Partikeln sowie zur Bildung von größeren Partikelagglomeraten im Fließbett. Diese Siliciumagglomerate sind im Produkt unerwünscht und stören aufgrund schlechterer Fließeigenschaften den Reaktorbetrieb erheblich. Ebenso haften Partikel an der Fließbettbewandung an und werden teilweise bis zum Aufschmelzen (T>1400° C) aufgeheizt. Die starke Überhitzung von Partikeln in direkter Nähe der Wellenleiteranschlüsse führte außerdem zu einer übermäßigen thermischen Belastung der Fließbettbewandung. Die Fluidisierung des Fließbettes und damit das Mischungsverhalten hat zwar eine ausgleichende Wirkung hinsichtlich der Temperaturverteilung im Fließbett, dies ist jedoch stark abhängig vom Grad der Fluidisierung. Je höher die Gasgeschwindigkeit, desto stärker werden Partikel vertikal und horizontal vermischt. Eine Erhöhung der Gasgeschwindigkeit weit über die Lockerungsgeschwindigkeit hat jedoch immer eine Erhöhung der nötigen Energiezufuhr zufolge, da das Fluidisiergas im allgemeinen mit deutlich geringerer Temperatur als die Partikel dem Fließbett zuströmt und sich bei der Durchströmung des Fließbettes annähernd auf dessen Temperatur erwärmt.

US 7029632 B2 offenbart einen Fließbettreaktor mit einer drucktragenden Hülle, einem inneren Reaktorrohr, das Wärmestrahlung transmittiert, einem Einlass für Siliciumpartikel, einem rohrförmigen Einlass zum Zuführen eines Reaktionsgases, der das Fließbett in eine Heizzone und eine darüberliegende Reaktionszone teilt, einer Gasverteilungseinrichtung für die Zufuhr eines Fluidisiergases in die Heizzone, einem Auslass für nicht abreagiertes Reaktionsgas, Fluidisiergas sowie die gas- oder dampfförmigen Produkte der Reaktion, einem Auslass für das Produkt, einer Heizvorrichtung sowie einer Energieversorgung für die Heizvorrichtung, wobei vorgeschlagen wird, dass die Heizvorrichtung eine Strahlungsquelle für Wärmestrahlung ist, die außerhalb des inneren Reaktorrohres und ohne direkten Kontakt zu diesem ringförmig um die Heizzone angeordnet ist und derart ausgebildet ist, dass sie mittels Wärmestrahlung die Siliciumteilchen in der Heizzone auf so eine Temperatur aufheizt, dass sich in der Reaktionszone die Reaktionstemperatur einstellt.

Auch hier sind Heizzone und Reaktionszone vertikal getrennt. Dies ermöglicht es, das Fließbett auch mit anderen Heizmethoden als mit Mikrowellen zu beheizen, da es in der Heizzone zu keiner Wandabscheidung kommen kann, weil dort kein siliciumhaltiges Gas vorliegt. Es ist eine Wärmestrahlungsheizung mit flächigen Heizerelementen vorgesehen, die die Wärme gleichmäßig über den Umfang des Fließbettes und örtlich definiert einbringt.
Der Hauptteil der Wärmestrahlung durchdringt das innere Reaktorrohr, das eine hohe Transmission für die Wärmestrahlung, die vom gewählten Heizer emittiert wird, besitzt, und wird direkt von den Siliciumpartikeln, die sich in direkter Wandnähe in der Heizzone befinden, absorbiert. So können die Siliciumpartikel im Fließbett gleichmäßig über den Umfang der Heizzone direkt beheizt werden. Nur ein geringer Anteil der Wärmestrahlung wird vom Reaktorrohr absorbiert und beheizt dieses.
Bei der Heizvorrichtung handelt es sich beispielsweise um Heizelemente aus dotiertem Silicium oder Graphit oder Siliciumcarbid, Quarzrohrstrahler, Keramikstrahler oder Metalldrahtstrahler. Insbesondere bevorzugt handelt es sich bei der Heizvorrichtung um ein mäanderförmig geschlitztes Rohr aus Graphit mit SiC-Oberflächenbeschichtung, das im Reaktor stehend oder hängend an den Elektrodenanschlüssen angeordnet ist.

Aus US 8017024 B2 ist bekannt, dass nach Beendigung der Abscheidung das Reaktorinnere gekühlt und mit einem Inertgas wie H₂, N₂, Ar, He oder einem Gemisch der genannten Gase gespült wird. Anschließend werden die abgekühlten Siliciumpartikel entnommen, der Reaktor demontiert, das Reaktorrohr durch ein neues ersetzt, der Reaktor wieder montiert und Siliciumpartikel in das Reaktorrohr eingefüllt. Anschließend werden die Siliciumpartikel aufgeheizt und ein neuer Abscheidevorgang beginnt. Bei den im Stand der Technik beschriebenen Reaktoren besteht das Problem, dass beim Ausfahren des Reaktors das Reaktorrohr, das üblicherweise aus Quarzglas besteht, zerstört wird. Dies kann Kontamination des granularen Polysiliciums zur Folge haben. Dies kann gemäß US 8017024 B2 verhindert werden, in dem auf die Demontage des Reaktors verzichtet und ein Ätzgas in den Reaktor geleitet wird, um den Wandbelag vom Reaktorrohr zu entfernen, wobei das Polysiliciumgranulat dem Reaktor vor der Ätzbehandlung entnommen wurde.

WO 2008/018760 A1 offenbart Schutzrohre für Heizvorrichtungen in einem Wirbelschichtreaktor, wobei sich die Heizvorrichtungen innerhalb des Schutzrohres befinden. Die Schutzrohre dienen dazu, Kontamination von Siliciumpartikeln durch die Heizvorrichtungen zu verhindern oder zu minimieren.

WO 93/20933 A1 beschreibt einen Suszeptor, der zwischen der Reaktorwand und einem Induktor angebracht ist. Die Reaktorwand wird durch Strahlungsheizung geheizt. Der Suszeptor ist elektrisch leitfähig und wird durch Induktion geheizt. Auf diese Weise kann eine einheitliche Temperaturverteilung der Reaktorwand erzielt werden. Der Suszeptor besteht aus hochtemperaturbeständigem, wärmeleitendem Material, bevorzugt aus Graphit.

Dieser Suszeptor wirkt jedoch wie ein Strahlungsschild und macht das Verfahren unwirtschaftlich.

Aus dieser Problematik ergab sich die Aufgabenstellung der Erfindung.

Die Aufgabe der Erfindung wird gelöst durch einen Reaktor zur Herstellung von granularem Polysilicium durch Abscheidung von polykristallinem Silicium auf Silicium-Keimpartikeln, umfassend einen Reaktorbehälter, ein Innen-Reaktorrohr für eine Wirbelschicht mit granularem Polysilicium und einen Reaktorboden innerhalb des Reaktorbehälters, eine Heizvorrichtung zum Heizen der Wirbelschicht im Innen-Reaktorrohr, wenigstens eine Bodengasdüse zur Zuführung von Fluidisierungsgas sowie wenigstens eine Reaktionsgasdüse zur Zuführung von Reaktionsgas, eine Zuführeinrichtung, um Silicium-Keimpartikel zuzuführen sowie eine Entnahmeleitung für granulares Polysilicium und eine Einrichtung zum Abführen von Reaktorabgas aus dem Reaktorbehälter, dadurch gekennzeichnet, dass sich zwischen Innen-Reaktorrohr und Heizvorrichtung ein zylinderförmiges Bauteil befindet, das auf seiner Mantelfläche Öffnungen aufweist, wobei wenigstens 5% und höchstens 95% der Mantelfläche offen sind und das Bauteil aus einem wärmeleitenden Material besteht, so dass Heizenergie durch Wärmestrahlung und Wärmeleitung auf das Bauteil übertragen werden und dieses zum Glühen bringen kann oder das Bauteil aus einem Material besteht, das für Strahlungsenergie der Heizvorrichtung durchlässig ist.

Unter dem Merkmal, dass wenigstens 5% und höchstens 95% der Mantelfläche des zylinderförmigen Bauteils offen sind, ist zu verstehen, dass ein Verhältnis von freier Fläche (Summe der Öffnungsflächen) zur gesamten Mantelfläche des Bauteils 5-95% beträgt.

Vorzugweise beträgt dieses Verhältnis 40-70%, besonders bevorzugt 45-60%.

Bei den Öffnungen kann es sich um Schlitze, Ausschnitte, Maschen, Bohrungen usw. handeln.

Das Bauteil kann beispielsweise die Form eines zylindrischen Gitters haben.

Nach oben oder nach unten oder in beide Richtungen (Grund- und Deckfläche des Zylinders) ist das Bauteil vorzugweise geöffnet. Das erleichtert die Demontage des Reaktors.

Bei der Heizvorrichtung kann es sich um einen mäanderförmigen Heizer oder um eine Vielzahl von Heizelementen bzw. Heizleisten handeln.

Vorzugweise besteht die Heizvorrichtung aus mehreren konzentrisch um das Innen-Reaktorrohr angeordneten Heizelementen. Zwischen den Heizelementen und dem Innen-Reaktorrohr befindet sich in diesem Fall vorzugweise das Bauteil, das ebenfalls konzentrisch um das Innen-Reaktorrohr angeordnet ist.

Vorzugweise besteht das Bauteil aus einem gut wärmeleitenden Material.

Vorzugweise befinden sich die Heizelemente in Öffnungen der Mantelfläche des Bauteils. Bei den Öffnungen kann es sich um Ausschnitte handeln, in denen sich die Heizleisten befinden.

Vorzugweise umfasst das Bauteil ein Material ausgewählt aus der Gruppe bestehend aus Graphit, CFC, Silicium, SiC und Quarzglas. Das Bauteil kann aus einem oder mehreren der genannten Materialien bestehen. Ebenso kann das Bauteil mit einem oder mehreren der genannten Materialien beschichtet sein.

Der Wirbelschichtreaktor besteht aus einem Reaktorbehälter, in den ein Innen-Reaktorrohr eingesetzt ist. Im Inneren des Reaktorrohres befindet sich die Wirbelschicht mit dem Polysilicium-Granulat. Die Wirbelschicht wird mittels der Heizvorrichtung geheizt. Als Zugase werden dem Reaktor das Fluidisierungsgas und das Reaktionsgasgemisch zugeführt. Die Gaszuführung erfolgt dabei gezielt über Düsen. Das Fluidisierungsgas wird über eine Bodengasdüse und das Reaktionsgasgemisch über sog. Sekundärgasdüsen (Reaktionsgasdüsen) zugeführt. Die Höhe der Sekundärgasdüsen kann sich von der Höhe der Bodengasdüsen unterscheiden. Im Reaktor bildet sich durch die Anordnung der Düsen eine blasenbildende Wirbelschicht mit zusätzlicher vertikaler Sekundärgaseindüsung aus. Über eine Zuführeinrichtung werden dem Reaktor Silicium-Keimpartikel zugeführt. Das Polysilicium-Granulat-Produkt wird über eine Entnahmeleitung am Reaktorboden entnommen. Über eine Einrichtung zum Abführen von Reaktorabgas wird das Reaktorabgas abgezogen.

Es hat sich überraschenderweise gezeigt, dass die Verwendung eines zuvor genannten Bauteils zwischen Heizvorrichtung und Reaktorrohr neben einer Vergleichmäßigung der Temperatur auch geeignet ist, die Heizvorrichtung während des Ausfahrens des Reaktors zu schützen.

Im Stand der Technik kam infolge des Auseinanderbrechens des Reaktorrohrs auch zu Beschädigungen an den Heizelementen. Dies kann durch die vorliegende Erfindung vermieden werden. Das Bauteil ist gegenüber brechenden Teilen des Reaktorrohres unempfindlich und kann wiederverwendet werden.

Zudem liegt anders als im Stand der Technik kein Strahlungsschild vor, da das Bauteil Öffnungen aufweist und damit der Energieeintrag in die Wirbelschicht auf einen wirtschaftlichere Art und Weise erfolgt.

Die Erfindung wird nachfolgend anhand von Figuren erläutert.

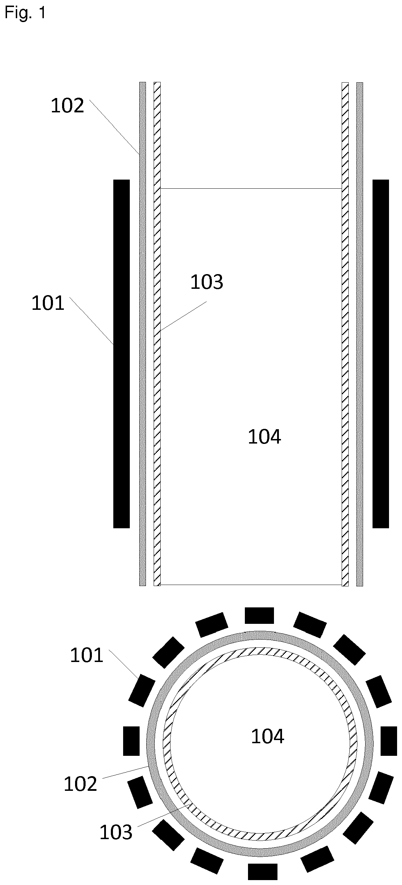

**Fig. 1** zeigt in zwei Ansichten schematisch, wie das Bauteil zwischen Heizern und Reaktorrohr angeordnet ist.
**Fig. 2** zeigte eine erste Ausführungsform des Bauteils.
**Fig. 3** zeigte eine zweite Ausführungsform des Bauteils.

### Liste der verwendeten Bezugszeichen

- **101**: Heizer
- **102**: Bauteil
- **103**: Innen-Reaktorrohr
- **104**: Wirbelschicht

Wirbelschicht **104** befindet sich im Innen-Reaktorrohr **103.** Zwischen Heizer **101** und Innen-Reaktorrohr **103** befindet sich das Bauteil **102**. Heizer **101** und Bauteil **102** sind konzentrisch um Innen-Reaktorrohr **103** angeordnet.

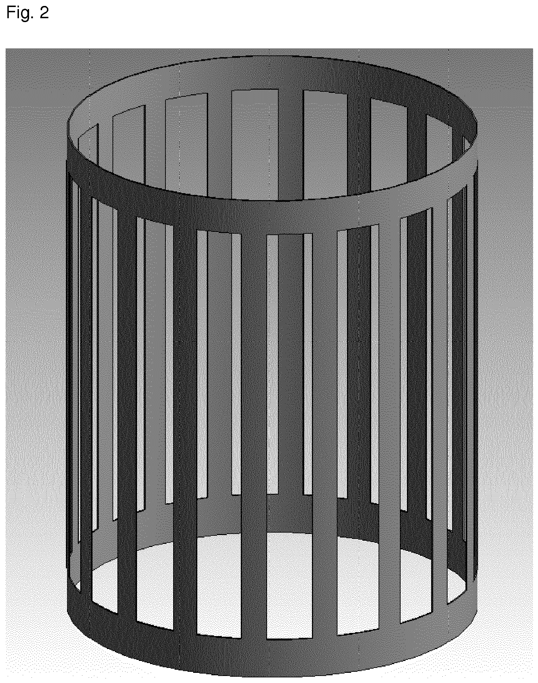

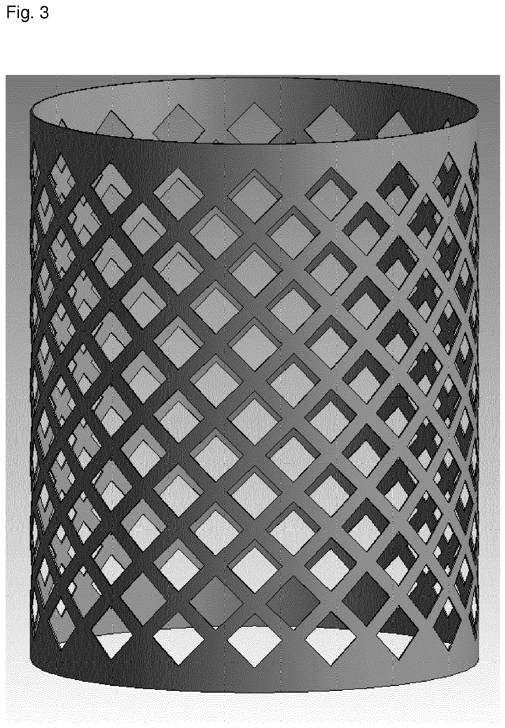

Die **Fig. 2** und **3** zeigen zwei Ausführungsformen von Bauteilen, die eingesetzt werden können, den allgemeinen Erfindungsgedanken jedoch in keiner Weise einschränken sollen.

In **Fig. 2** ist ein Bauteil dargestellt, bei dem 55% der Mantelfläche offen sind. Die Öffnungen haben eine rechteckige Form (Schlitze in Längsrichtung des Zylinders) und sind gleichmäßig auf der Mantelfläche des zylindrischen Bauteils verteilt. Diese Ausführungsform eignet sich besonders gut, um Heizelemente in den Öffnungen anzuordnen.

In **Fig. 3** ist ein Bauteil dargestellt, bei dem 47% der Mantelfläche offen sind. Auf der Mantelfläche des zylindrischen Bauteils ist eine Vielzahl an quadratischen Öffnungen vorhanden.

Die Erfindung betrifft auch ein Verfahren zur Herstellung von granularem Polysilicium unter Verwendung eines erfindungsgemäßen Reaktors, umfassend Fluidisierung von Silicium-Keimpartikeln mittels einer Gasströmung in einer Wirbelschicht, die mittels einer Heizvorrichtung aufgeheizt wird, wobei durch Zugabe eines siliciumhaltigen Reaktionsgases mittels Pyrolyse polykristallines Silicium an den heißen Keimpartikeloberflächen abgeschieden wird, wodurch das granulare Polysilicium entsteht.

Vorzugweise wird das Verfahren kontinuierlich betrieben, indem durch Abscheidung im Durchmesser angewachsene Partikel aus dem Reaktor abgeführt und frische Keimpartikel zudosiert werden.

Die Temperatur der Wirbelschicht im Reaktionsbereich beträgt bevorzugt 850-1100° C, besonders bevorzugt 900-1050° C, ganz besonders bevorzugt 920-970° C.

Beim Fluidisierungsgas handelt es sich vorzugsweise um Wasserstoff.

Das Reaktionsgas wird über eine oder mehrere Düsen in die Wirbelschicht eingedüst.

Die lokalen Gasgeschwindigkeiten am Austritt der Düsen betragen vorzugsweise 0,5 bis 200 m/s.

Die Konzentration des siliciumhaltigen Reaktionsgases beträgt bezogen auf die gesamte durch die Wirbelschicht strömende Gasmenge vorzugsweise 10 mol-% bis 50 mol-%, besonders bevorzugt 15 mol-% bis 40 mol-%.

Die Konzentration des siliciumhaltigen Reaktionsgases in den Reaktionsgasdüsen beträgt bezogen auf die gesamte durch die Reaktionsgasdüsen strömende Gasmenge vorzugsweise 20 mol-% bis 80 mol-%, besonders bevorzugt 30 mol-% bis 60 mol-%. Als siliciumhaltiges Reaktionsgas kommt vorzugweise Trichlorsilan zum Einsatz.

Der Reaktordruck bewegt sich im Bereich von 0 bis 7 barü, vorzugsweise im Bereich 0,5 bis 4,5 barü.

Bei einem Reaktor mit einem Durchmesser von z. B. 400 mm beträgt der Massenstrom an Trichlorsilan vorzugsweise 200 bis 400 kg/h. Der Wasserstoffvolumenstrom beträgt vorzugsweise 100 bis 300 Nm³/h. Für größere Reaktoren sind höhere Mengen an TCS und H₂ bevorzugt.

Dem Fachmann ist klar, dass einige Prozessparameter idealerweise abhängig von der Reaktorgröße ausgewählt werden. Auch Reaktorheizleistung, KeimpartikelDosierrate und das Bettgewicht sind bei größeren Reaktoren z. B. bei einem Reaktor mit 800 mm Durchmesser vorzugsweise höher als die zuvor genannten Werte.

Um dies anschaulich zu verdeutlichen, sind im Folgenden die Bereiche der auf die Reaktorquerschnittsfläche normierten Betriebsdaten zusammengestellt, in denen das im Rahmen dieser Erfindung beschriebene Verfahren Gültigkeit besitzt.

Der spezifische Massenstrom an Trichlorsilan beträgt vorzugsweise 1600-5500 kg/(h*m²).

Der spezifische Wasserstoffvolumenstrom beträgt vorzugsweise 800-4000 Nm³/(h*m²).

Das spezifische Bettgewicht beträgt vorzugsweise 800-2000 kg/m².

Die spezifische Keimpartikeldosierrate beträgt vorzugsweise 8-25 kg/(h*m²).

Die spezifische Reaktorheizleistung beträgt vorzugsweise 800-3000 kW/m².

Der mittlere Durchmesser der Siliciumpartikel (Keimpartikel) beträgt vorzugsweise mindestens 400 µm.

Das granulare Polysilicium weist vorzugweise Partikelgrößen von 150-10000 µm auf, wobei ein massenbezogener Medianwert einer Partikelgrößenverteilung 850-2000 µm beträgt.

Die Verweilzeit des Reaktionsgases in der Wirbelschicht beträgt vorzugsweise 0,1 bis 10 s, besonders bevorzugt 0,2 bis 5 s.

## Patentansprüche

1. Reaktor zur Herstellung von granularem Polysilicium durch Abscheidung von polykristallinem Silicium auf Silicium-Keimpartikeln, umfassend einen Reaktorbehälter, ein Innen-Reaktorrohr für eine Wirbelschicht mit granularem Polysilicium und einen Reaktorboden innerhalb des Reaktorbehälters, eine Heizvorrichtung zum Heizen der Wirbelschicht im Innen-Reaktorrohr, wenigstens eine Bodengasdüse zur Zuführung von Fluidisierungsgas sowie wenigstens eine Reaktionsgasdüse zur Zuführung von Reaktionsgas, eine Zuführeinrichtung, um Silicium-Keimpartikel zuzuführen sowie eine Entnahmeleitung für granulares Polysilicium und eine Einrichtung zum Abführen von Reaktorabgas aus dem Reaktorbehälter, **dadurch gekennzeichnet, dass** sich zwischen Innen-Reaktorrohr und Heizvorrichtung ein zylinderförmiges Bauteil befindet, das auf seiner Mantelfläche Öffnungen aufweist, wobei wenigstens 5% und höchstens 95% der Mantelfläche offen sind und das Bauteil aus einem wärmeleitenden Material besteht, so dass Heizenergie durch Wärmestrahlung und Wärmeleitung auf das Bauteil übertragen werden und dieses zum Glühen bringen kann, oder das Bauteil aus einem Material besteht, das für Strahlungsenergie der Heizvorrichtung durchlässig ist.

2. Reaktor nach Anspruch 1, wobei 40-70% der Mantelfläche des Bauteils offen sind.

3. Reaktor nach Anspruch 2, wobei 45-60% der Mantelfläche des Bauteils offen sind.

4. Reaktor nach einem der Ansprüche 1 bis 3, wobei es sich bei der Heizvorrichtung um einen mäanderförmigen Heizer oder um eine Vielzahl von Heizelementen handelt.

5. Reaktor nach einem der Ansprüche 1 bis 4, wobei die Heizvorrichtung mehrere konzentrisch um das Innen-Reaktorrohr angeordnete Heizelemente umfasst, wobei das Bauteil ebenfalls konzentrisch um das Innen-Reaktorrohr angeordnet ist.

6. Reaktor nach einem der Ansprüche 1 bis 5, wobei die Heizvorrichtung Heizelemente umfasst, die in Öffnungen des Bauteils angeordnet sind.

7. Reaktor nach einem der Ansprüche 1 bis 6, wobei das Bauteil ein Material ausgewählt aus der Gruppe bestehend aus Graphit, CFC, Silicium, SiC und Quarzglas umfasst, wobei das Bauteil aus einem oder mehreren der genannten Materialien besteht oder mit einem oder mehreren der genannten Materialien beschichtet ist.

8. Verfahren zur Herstellung von granularem Polysilicium unter Verwendung eines Reaktors nach einem der Ansprüche 1 bis 7, umfassend Fluidisierung von Silicium-Keimpartikeln mittels einer Gasströmung in einer Wirbelschicht, die mittels einer Heizvorrichtung aufgeheizt wird, wobei durch Zugabe eines siliciumhaltigen Reaktionsgases mittels Pyrolyse polykristallines Silicium an den heißen Keimpartikeloberflächen abgeschieden wird, wodurch das granulare Polysilicium entsteht.

## Claims

1. Reactor for preparing granular polysilicon by deposition of polycrystalline silicon on silicon seed particles, which comprises a reaction vessel, an inner reactor tube for a fluidized bed comprising granular polysilicon and a reactor bottom within the reactor vessel, a heating device for heating the fluidized bed in the inner reactor tube, at least one bottom gas nozzle for introduction of fluidizing gas and at least one reaction gas nozzle for introduction of reaction gas, a feed device to introduce silicon seed particles and also an offtake line for granular polysilicon and a device for discharging reactor offgas from the reactor vessel, **characterized in that** a cylindrical component which has openings on its cylindrical surface, with at least 5% and not more than 95% of the cylindrical surface being open, is located between inner reactor tube and heating device and the component consists of a thermally conductive material so that heat energy is transferred by heat radiation and heat conduction to the component and the latter can be brought to glowing, or the component consists of a material which is permeable for radiation energy from the heating device.

2. Reactor according to Claim 1, wherein 40-70% of the cylindrical surface of the component is open.

3. Reactor according to Claim 2, wherein 45-60% of the cylindrical surface of the component is open.

4. Reactor according to any of Claims 1 to 3, wherein the heating device is a heater having a meandering shape or a plurality of heating elements.

5. Reactor according to any of Claims 1 to 4, wherein the heating device comprises a plurality of heating elements arranged concentrically around the inner reactor tube and the component is likewise arranged concentrically around the inner reactor tube.

6. Reactor according to any of Claims 1 to 5, wherein the heating device comprises heating elements which are arranged in openings of the component.

7. Reactor according to any of Claims 1 to 6, wherein the component comprises a material selected from the group consisting of graphite, CFC, silicon, SiC and fused silica, with the component consisting of one or more of the materials mentioned or being coated with one or more of the materials mentioned.

8. Process for preparing granular polysilicon using a reactor according to any of Claims 1 to 7, which comprises fluidization of silicon seed particles by means of a gas stream in a fluidized bed which is heated by means of a heating device, with polycrystalline silicon being deposited on the hot seed particle surfaces by introduction of a silicon-containing reaction gas and pyrolysis thereof so as to form the granular polysilicon.

## Revendications

1. Réacteur de fabrication de polysilicium granulaire par précipitation de silicium polycristallin sur des particules germes de silicium, comprenant un réacteur, une conduite de réacteur interne pour un réacteur à lit fluidisé avec du polysilicium granulaire et un lit de réacteur à l'intérieur du réacteur, un dispositif de chauffage pour chauffer le lit fluidisé dans la conduite de réacteur interne, au moins une buse à gaz de fond pour acheminer du gaz de réaction, un dispositif d'acheminement pour acheminer des particules germes de silicium ainsi qu'une conduite de prélèvement pour du polysilicium granulaire et un dispositif d'extraction de gaz de réaction hors du réacteur, **caractérisé en ce qu'**il y a entre la conduite de réacteur interne et le dispositif de chauffage une pièce de forme cylindrique qui présente des ouvertures sur sa surface d'enveloppe, où au moins 5 % et au maximum 95 % de la surface d'enveloppe sont ouverts et la pièce se compose d'un matériau conducteur de chaleur, de sorte que de l'énergie thermique soit transmise sur la pièce par rayonnement thermique et conduction thermique et cela peut entraîner son rougeoiement, ou la pièce se compose d'un matériau perméable à l'énergie de rayonnement du dispositif de chauffage.

2. Réacteur selon la revendication 1, dans lequel 40 à 70 % de la surface d'enveloppe de la pièce sont ouverts.

3. Réacteur selon la revendication 2, dans lequel 45 à 60 % de la surface d'enveloppe de la pièce sont ouverts.

4. Réacteur selon une des revendications 1 à 3, où le dispositif de chauffage est un élément de chauffage de forme de méandre ou de plusieurs éléments de chauffage.

5. Réacteur selon une des revendications 1 à 4, où le dispositif de chauffage comprend plusieurs éléments de chauffage disposés concentriquement autour de la conduite de réacteur interne, la pièce étant elle aussi disposée concentriquement autour de la conduite de réacteur interne.

6. Réacteur selon une des revendications 1 à 5, où le dispositif de chauffage comprend des éléments de chauffage disposés dans des ouvertures de la pièce.

7. Réacteur selon une des revendications 1 à 6, où la pièce comprend un matériau choisi dans le groupe constitué du graphite, du CFC, du silicium, du SiC et du verre de quartz, la pièce étant constituée d'un ou plusieurs desdits matériaux ou étant recouverte d'un ou plusieurs desdits matériaux.

8. Procédé de fabrication de polysilicium granulaire en utilisant un réacteur selon une des revendications 1 à 7, comprenant la fluidisation de particules germes de silicium au moyen d'un écoulement de gaz dans un lit fluidisé chauffé au moyen d'un dispositif de chauffage, où du silicium polycristallin est précipité au niveau des surfaces de particules germes chaudes par ajout d'un gaz de réaction contenant du silicium, grâce à quoi il se forme du polysilicium granulaire.
